# EUROPÄISCHE PATENTSCHRIFT

(11) **EP 0 696 880 B1**
(45) Veröffentlichungstag und Bekanntmachung des Hinweises auf die Patenterteilung: **26.08.1998**
(21) Anmeldenummer: 95111825.6
(22) Anmeldetag: 28.07.1995
(51) Int. Cl.: H05K 1/18, H05K 1/14

(54) **Kunststoffgehäuse mit einer schwingungsdämpfenden Lagerung eines bondbaren Elements**
Plastic housing having a vibration damped mounting of a bondable element
Boîtier en matière plastique comprenant un élément soudable par bonding fixé de telle sort que les vibrations soient amorties

(30) Priorität: 10.08.1994 DE 4428320
(43) Veröffentlichungstag der Anmeldung: 14.02.1996
(73) Patentinhaber: DODUCO GmbH, 75181 Pforzheim (DE)
(72) Erfinder: Kühnle, Andreas, D-75438 Knittlingen (DE); Ney, Joachim, D-75223 Niefern (DE); Normann, Norbert, Dr., D-75223 Niefern (DE)
(74) Vertreter: Twelmeier, Ulrich, Dipl. Phys.

(56) Entgegenhaltungen:
- EP-A- 0 603 739
- US-A- 3 863 881
- US-A- 4 211 890
- US-A- 4 833 570
- US-A- 4 872 937
- PATENT ABSTRACTS OF JAPAN vol. 17, no. 89 (E-1323), 22.Februar 1993 & JP-A-04 282525 (TOSHIBA CORP.)

## Beschreibung

Die Erfindung betrifft ein Kunststoffgehäuse mit einer schwingungsdämpfenden Lagerung eines bondbaren Elements.

Die elektrische Verbindung von fest in einem Kunststoffgehäuse eingebetteten Metallkontakten mit einem im Kunststoffgehäuse aufgenommenen elektrischen Modul wird in vielen Fällen mit einer sog. Drahtbond-Technik durchgeführt. Hierbei ist es für die Qualität und Zuverlässigkeit der Bondverbindung von entscheidender Bedeutung, daß die Fläche, auf die gebondet wird, also die Kontaktfläche der im Kunststoffgehäuse eingebetteten Metallkontakte, während des Bond-Vorgangs nicht mitschwingen kann.

Es ist daher Aufgabe der Erfindung, ein Kunststoffgehäuse der eingangs genannten Art derart weiterzuentwickeln, daß sich negativ auf das Bond-Ergebnis auswirkende Schwingungen des bondbaren Elements eliminiert oder zumindest reduziert werden.

Diese Aufgabe wird erfindungsgemäß durch die im Anspruch 1 angegebenen Merkmale gelöst.

Erfindungsgemäß ist also vorgesehen, daß zwischen dem bondbaren Element und dem Gehäusekörper des Kunststoffgehäuses ein aufgespritztes, aufgedrucktes oder aufdispensiertes Dämpfungselement aus elastischem Material angeordnet ist. Durch diese Maßnahme wird in vorteilhafter Art und Weise erreicht, daß beim erfindungsgemäßen Kunststoffgehäuse keine störenden Resonanzstellen im Bereich der Bondfrequenz im System Gehäusekörper-bondbares Element auftreten, die sich negativ auf die Bondergebnisse auswirken. Das erfindungsgemäße Kunststoffgehäuse zeichnet sich außerdem dadurch aus, daß es kostengünstig herstellbar ist, da das Anspritzen, Aufdrucken oder Aufdispensieren des Dämpfungselements aus elastischem Material, insbesondere aus elastomeren Kunststoff, besonders einfach durchführbar ist.

Vorteilhafte Weiterbildungen der Erfindung ergeben sich aus den Unteransprüchen.

Weitere Einzelheiten der Erfindung sind dem Ausführungsbeispiel zu entnehmen, das im folgenden anhand der einzigen Figur beschrieben wird. Es zeigt:

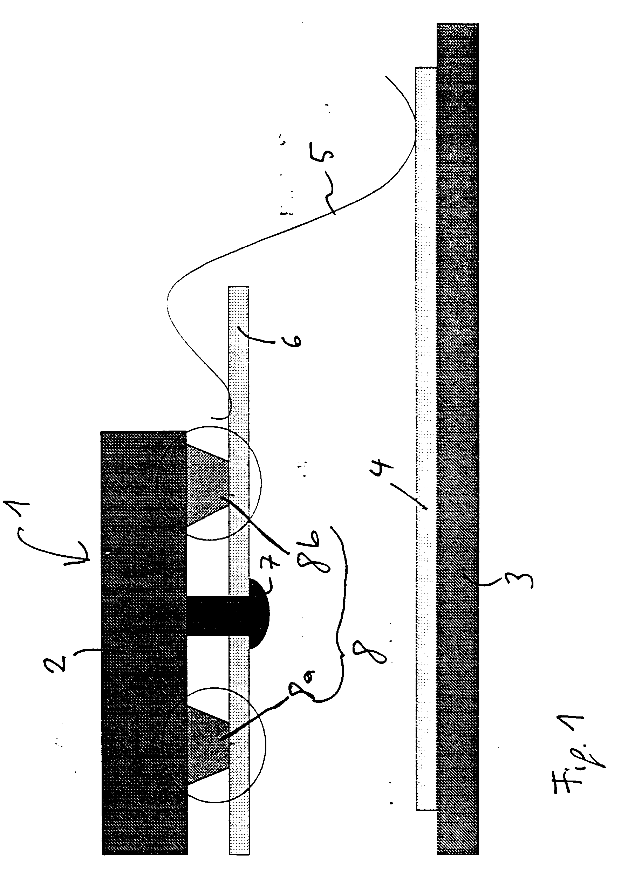

- Figur 1: einen Schnitt durch ein Ausführungsbeispiel eines Kunststoffgehäuses.

Das in Figur 1 dargestellte Ausführungsbeispiel eines allgemein mit 1 bezeichneten und nur ausschnittsweise dargestellten Kunststoffgehäuses weist einen Gehäusekörper 2 und einen Gehäuseboden 3 auf.

Am Gehäuseboden 3 ist ein elektrisches Modul 4 - etwa eine Leiterplatte oder ein Hybridsubstrat - angeordnet, welches mit einem entsprechenden Bonddraht 5 mit einem bondbaren Element 6, etwa einer über eine Ultraschallverschweißung 7 mit dem Gehäusekörper 2 verbundenen Leiterplatte oder - nicht dargestellt - mit in den Gehäusekörper 2 eingebetteten Kontaktelementen - zu verbinden ist.

Wichtig ist nun, daß zwischen dem bondbaren Element 6 und dem Gehäusekörper 2 eine aus einem oder mehreren Dämpfungselementen 8a, 8b bestehende Dämpfungseinheit 8 angeordnet ist. In vorteilhafter Art und Weise bestehen diese Dämpfungselemente 8a, 8b aus elastischem Material, insbesondere aus elastomerem Kunststoff, die in einem der Herstellung des Kunststoffgehäuses direkt folgenden Spritzzyklus mittels einer an sich bekannten und daher nicht näher beschriebenen Zweifarben-Spritzmaschine an den Gehäusekörper 2 angespritzt wurden.

Es ist aber auch möglich, die Dämpfungselemente 8a, 8b aus elastischem Material auf das bondbare Element 6 aufzudrucken oder aufzudispensieren und danach mittels Wärmeoder UV-Strahlung auszuhärten. Die derart hergestellten bondbaren Elemente 6 mit aufdispensierten oder aufgedruckten Dämpfungselementen 8a, 8b aus elastischem Material, insbesondere aus elastomerem Kunststoff, werden wiederum mittels Ultraschallverschweißung 7 am Gehäusekörper 2 montiert. Es ist aber auch denkbar, daß diese bondbaren Elemente 6 mit ein-, zwei- oder mehrseitig aufgedruckten oder aufdispensierten Dämpfungselementen 8a, 8b in einer von der Einbettung metallischer Kontaktstifte in den Gehäusekörper 2 her bekannten Art und Weise bei dessen Spritzen eingebettet werden.

Es soll noch erwähnt werden, daß es auch möglich ist, als elastisches Material für die Dämpfungselemente 8a, 8b einen Acrylklebstoff, insbesondere einen einkomponentigen, lichthärtenden Klebstoff auf Polyethermethacrylatbasis einzusetzen.

Zusammenfassend ist festzustellen, daß durch die zwischen dem Gehäusekörper des Kunststoffgehäuses 1 und dem bondbaren Element 7 angeordnete Dämpfungselemente 8a, 8b in vorteilhafter Art und Weise erreicht wird, daß Resonanzstellen im System Gehäusekörper - bondbares Element im Bereich der Bondfrequenz vollständig eliminiert oder zumindest reduziert werden, sodaß auf besonders einfache Art und Weise qualitativ hochwertige Bondergebnisse erzielbar sind.

## Patentansprüche

1. Kunststoffgehäuse mit einer schwingungsdämpfenden Lagerung eines bondbaren Elements (6), welches fest mit einem Gehäusekörper (2) des Kunststoffgehäuses (1) verbunden ist, wobei zwischen dem bondbaren Element (6) und dem Gehäusekörper (2) des Kunststoffgehäuses (1) mindestens ein Dämpfungselement (8a,8b) aus elastischem Material aufgespritzt, aufdispensiert oder aufgedruckt ist.

2. Kunststoffgehäuse nach Anspruch 1, **dadurch gekennzeichnet**, daß das Dämpfungselement (8a,8b) aus elastischem Material an den Gehäusekörper (2) angespritzt ist.

3. Kunststoffgehäuse nach Anspruch 1, **dadurch gekennzeichnet**, daß das Dämpfungselement (8a,8b) aus elastischem Material auf das bondbare Element (6) aufgedruckt oder aufdispensiert ist.

4. Kunststoffgehäuse nach einem der Ansprüche 1 bis 3, **dadurch gekennzeichnet**, daß das bondbare Element (6) mechanisch am Gehäusekörper (2) befestigt ist.

5. Kunststoffgehäuse nach Anspruch 3, **dadurch gekennzeichnet**, daß das bondbare Element (6) mit aufgedrucktem oder aufdispensiertem Dämpfungselement (8a,8b) aus elastischem Material in den Gehäusekörper (2) eingebettet ist.

6. Kunststoffgehäuse nach einem der Ansprüche 1 bis 5, **dadurch gekennzeichnet**, daß das elastische Material ein elastomerer Kunststoff oder ein Acrylklebstoff, insbesondere ein einkomponentiger, lichthärtender Klebstoff auf Polyethermethacrylatbasis ist.

7. Bondbares Element für ein Kunststoffgehäuse nach Anspruch 1, **dadurch gekennzeichnet**, daß auf das bondbare Element (6) mindestens ein Dämpfungselement (8a,8b) aus elastischem Material aufgedruckt oder aufdispensiert ist.

## Claims

1. Plastic package having a vibration-damping mounting for a bondable element (6) which is firmly connected to a package body (2) of the plastic package (1), at least one damping element (8a, 8b) of elastic material being injection-moulded on, dispensed on or printed on between the bondable element (6) and the package body (2) of the plastic package (1).

2. Plastic package according to Claim 1, characterized in that the damping element (8a, 8b) of elastic material is injection-moulded onto the package body (2).

3. Plastic package according to Claim 1, characterized in that the damping element (8a, 8b) of elastic material is printed or dispensed onto the bondable element (6).

4. Plastic package according to one of Claims 1 to 3, characterized in that the bondable element (6) is mechanically fastened to the package body (2).

5. Plastic package according to Claim 3, characterized in that the bondable element (6) with printed-on or dispensed-on damping element (8a, 8b) of elastic material is embedded in the package body (2).

6. Plastic package according to one of Claims 1 to 5, characterized in that the elastic material is an elastomeric plastic or an acrylic adhesive, in particular a one-component, light-curing adhesive based on polyether methacrylate.

7. Bondable element for a plastic package according to Claim 1, characterized in that at least one damping element (8a, 8b) of elastic material is printed or dispensed onto the bondable element (6).

## Revendications

1. Boîtier en matière plastique comprenant un élément (6) soudable par bonding fixé de telle sorte que les vibrations soient amorties, qui est relié de façon fixe à un corps du boîtier (2) en matière plastique (1), au moins un élément d'amortissement (8a, 8b) à base de matériau élastique étant appliqué par injection, répartition uniforme ou pression entre l'élément soudable par bonding (6) et le corps du boîtier (2) en matière plastique (1).

2. Boîtier en matière plastique selon la revendication 1, caractérisé en ce que l'élément d'amortissement (8a, 8b) à base de matériau élastique est injecté sur le corps du boîtier (2).

3. Boîtier en matière plastique selon la revendication 1, caractérisé en ce que l'élément d'amortissement (8a, 8b) à base de matériau élastique est appliqué par pression ou répartition uniforme sur l'élément (6) soudable par bonding.

4. Boîtier en matière plastique selon l'une quelconque des revendications 1 à 3, caractérisé en ce que l'élément (6) soudable par bonding est fixé de façon mécanique sur le corps du boîtier (2).

5. Boîtier en matière plastique selon la revendication 3, caractérisé en ce que l'élément soudable par bonding (6) avec un élément d'amortissement (8a, 8b) appliqué par pression ou répartition uniforme et à base de matériau plastique est inséré dans le corps du boîtier (2).

6. Boîtier en matière plastique selon l'une quelconque des revendications 1 à 5, caractérisé en ce que le matériau élastique est un plastique élastomère ou une colle acrylique, en particulier une colle à un composant et durcissant à la lumière et à base de polyéther-méthacrylate.

7. Elément soudable par bonding pour un boîtier en matière plastique selon la revendication 1, caractérisé en ce qu'au moins un élément d'amortissement (8a, 8b) à base de matériau élastique est appliqué par répartition uniforme ou pression sur l'élément (6) soudable par bonding.
